# EUROPEAN PATENT SPECIFICATION

(11) **EP 1 292 455 B1**
(45) Date of publication and mention of the grant of the patent: **11.04.2012**
(21) Application number: 01938282.9
(22) Date of filing: 31.05.2001
(51) Int. Cl.: B42D 15/10, G06K 19/02

(54) **A METHOD AND AN APPARATUS FOR MANUFACTURING A SMART LABEL INLET WEB**
VERFAHREN UND VORRICHTUNG ZUR HERSTELLUNG EINES BANDES MIT CHIPETIKETTEN
PROCEDE ET APPAREIL DE FABRICATION DE BANDE CONTINUE D'ETIQUETTES A PUCE

(30) Priority: 06.06.2000 FI 20001344
(43) Date of publication of application: 19.03.2003
(73) Proprietor: UPM RFID Oy, 33960 Pirkkala (FI)
(72) Inventor: STRÖMBERG, Samuli, FIN-33100 Tampere (FI); HANHIKORPI, Marko, FIN-33960 Tampere (FI); NUORELA, Ilkka, FIN-37630 Valkeakoski (FI); TIRKKONEN, Mikko, FIN-33210 Tampere (FI); LINDSTRÖM, Timo, FIN-33300 Tampere (FI); KYTÖLÄ, Lari, FIN-41330 Vihtavuori (FI)
(74) Representative: HOFFMANN EITLE
(86) International application number: PCT/FI2001/000520
(87) International publication number: WO 2001/095241

(56) References cited:
- EP-A1- 0 249 266
- WO-A1-98/49652
- WO-A1-99/24934
- DE-A1- 19 634 473
- US-A- 4 954 814
- US-A- 5 994 263

## Description

The present invention relates to a method and a device for the manufacture of a smart label inlet web.

A smart label inlet web comprises successive smart labels suitably spaced in a continuous sequence on a back web. The smart label inlet web is normally used as a raw material for further processing in the manufacture of a smart label product. At the stage of further processing e.g. by a printing machine, the smart label inlet web is introduced between a facing paper and a back paper for a label, before the ready labels are punched off the web.

In the present application, smart labels refer to labels comprising an RF-ID circuit (identification) or an RF-EAS circuit (electronic article surveillance). A smart label web consists of a sequence of successive and/or adjacent smart labels.

A problem in the manufacture of a smart label inlet web is, for example, that the attachment of an integrated circuit to the smart label must be performed on a different production line than the attachment of a surface web, a smart label web and a back web to each other. This leads to complex steps in the process, slowing down the production and increasing the production costs.

One problem in the process of manufacturing a smart label inlet web is the adherence of the integrated circuit to the circuitry pattern in such a way that the smart label remains functional, wherein a so-called underfill is required for successful adherence. The underfill levels out tensions between the chip and its substrate, due to thermal expansion. The underfill also prevents the movement of the solder joint and the development of fractures in the solder joint. By adding filler particles in the underfill, the underfill can be stiffened to prevent deflection of the joint. Prior art underfill techniques include for example C4 technology, solder flip-chip (FC) joint, metallurgic joint, isotropically conductive adhesive (ICA) joint, anisotropically conductive adhesive or film (ACA or ACF) joint, and non-conductive adhesive (NCA) joint. Techniques that are suitable for use in connection with the smart label web presented in this application include isotropically conductive adhesive joint, non-conductive adhesive joint, anisotropically conductive adhesive joint, and, in some cases, solder flip-chip joint.

The underfill is a problematic point in the process, because it requires a separate process step which takes a relatively long time due to the curing time required by the underfills, typically several minutes. When an anisotropically conductive adhesive joint and a non-conductive adhesive joint are used in the process, the curing of the adhesive is required under pressure, wherein the curing must be performed by installed thermal resistors. The production line is thus expensive and inflexible.

WO-A-98/49652 discloses a combination of features falling within the scope of the preamble of independent Claims 1 and 14.

Further background technology is disclosed in WO-A-99/24934 and DE-A-19634473.

By means of the method and the device according to the invention, it is possible to avoid the above-mentioned problems. The method of the invention is characterized in that: integrated circuits are attached in a continuous manner to the circuitry pattern of each smart label on the smart label web before the combination of the webs on the same production line, the webs are combined so that the smart label web is laminated between the surface and back webs, the adhesive provided on one side of the surface web forms encapsulation for the integrated circuits attached to the circuitry patterns on the smart label web, and the back web is a release paper. The device according to the invention is characterized in that: the device for the manufacture of a smart label inlet web further comprises means for attaching integrated circuits in a continuous manner to the circuitry pattern of each smart label on the smart label web, on the same production line, before the combination of the webs, and the back web is a release paper.

An important feature of the invention is that the attachment of the integrated circuit on a chip to the smart label is performed on the same production line on which the surface web, the smart label web and the back web are attached to each other.

With embodiments of the method of the invention, the process of manufacturing the smart label inlet web can be speeded up and the production costs can be reduced. As the attachment of the integrated circuit to the circuitry pattern is performed on the same production line as the attachment of the surface web, the smart label web and the back web, the attachment can also be made without an underfill. The use of an underfill can be abandoned with the new method, because
- the smart label web is flexible, wherein the joint is not subjected to a great mechanical and thermomechanical stress, but the flexible sub strate is used as a kind of a shock absorber,
- a highly cross-linked adhesive is provided on and around the integrated circuit on the chip, encapsulating the integrated circuit and thereby preventing its movement, and
- the smart label is, in principle, a disposable product, and the quality requirements set for it, such as resistance to mechanical stress or to variations in temperature and moisture, are lower than for most other electronic products.

To enable a better understanding of the invention, and to show how the same may be carried into effect, reference will now be made, by way of example only, to the accompanying drawings, in which:-
Fig. 1 shows a smart label web in a top view,
Fig. 2 shows various techniques for attaching an integrated circuit on a chip in a side view,
Figs. 3 to 5 show some processes of manufacturing a smart label inlet web in schematic views, and
Fig. 6 shows a side view of the ready smart label inlet web.

The smart label web is a carrier web containing smart labels one after each other. The smart label web can be for example a plastic film. The smart label can be manufactured by printing a circuitry pattern with an electroconductive printing ink on a film, by etching the circuitry pattern on a metal film, by punching the circuitry pattern from a metal film, or by winding the circuit pattern of for example a copper wire. The electrically operating radio frequency identification (RFID) circuit of the smart label is a simple electric oscillating circuit (RCL circuit) operating at a defined frequency. The circuit consists of a coil, a capacitor and an integrated circuit on a chip. The integrated circuit comprises an escort memory and an RF part which is arranged to communicate with a reader device. Also the capacitor of the RCL circuit can be integrated on the chip.

The integrated circuit on the chip is attached to the circuitry pattern by the flip-chip technique, known as such, or in such a way that the underfill is excluded from the joint. If an underfill is used, the smart label web is unwound and a solder bump is formed on its surface, at a suitable location on the circuitry pattern. The integrated circuit on the chip is attached to the solder bump which has been brought to a fluid state again, and the space between the chip and the smart label web is filled with an adhesive used as an underfill. The adhesive is passed in between the chip and the smart label web by the effect of the capillary phenomenon. The adhesive is quickly cross-linked. Integrated circuits are attached to each smart label of the smart label web in a continuous manner.

When no underfill is used, the solder bump is formed onto the circuitry pattern and brought into a fluid state again in connection with the attachment of the integrated circuit. The adhesive of the surface web forms the required encapsulation around the integrated circuit to replace the underfill, wherein e. g. the displacement of the circuit in the lateral direction is prevented.

After the attachment of the integrated circuit, the smart label web is led to the same nip as the back web and the surface web, the webs being attached to each other (combined) in the nip. The integrated circuits are attached in a continuous manner in such a way that at the same time when the surface web, the smart label web and the back web are attached in the nip, integrated circuits are attached to the smart label web on a suitable section of the production line preceding the nip. As the integrated circuit on the chip is brittle and may be damaged, if there are angles with a small radius in the manufacturing process and/or if the smart label is pressed with a too hard compression load for example in a hard nip, the method according to the invention applies a nip which is longer than a nip formed by hard rolls and in which the pressure per unit area is lower than in a nip formed by rolls with a hard surface.

The surface of the back web, which may be for example a release paper with a silicon coating, is provided with an adhesive. The adhesive can be any adhesive that is suitable for the purpose, for example a pressure-sensitive adhesive (PSA) which is easily adhered at room temperature.

The surface web is a film provided with an adhesive, such as a hot-melt adhesive, on its lower surface, i.e. on the side of the smart label. The hot-melt adhesive is preferably curable by radiation, wherein the adherence of the adhesive can be controlled by controlling the quantity of the radiation dose. Suitable methods for curing by radiation include curing by ultraviolet radiation, curing by an electron beam, or curing by microwaves. The adhesive of the surface web can be used to form an encapsulation for the integrated circuit on the chip, to replace an underfill. The surface web is a plastic film, preferably a polyolefine film, such as a polypropylene or polyethylene film.

The continuous back, smart label and surface webs are attached to each other by introducing them simultaneously into a nip, which can be for example a nip formed by two rolls or a nip formed by a roll and a belt. In this way, a blank is formed for the smart label inlet web. The adhesive of the back web adheres to the lower surface of the smart label web, and the adhesive of the surface web adheres to the upper surface of the smart label web. Before the nip, the adhesive can be suitably heated e.g. with an infrared heater, to provide the adhesive with suitable properties of adhesion to the smart label web. At least one of the contact surfaces forming the nip, such as rolls or belts, has a resilient surface, wherein a nip is formed which is longer than a nip formed by rolls with a hard surface. The blank for the smart label inlet web, formed by the attached webs, is led to radiation, wherein the adhesive is finally cross-linked. The material left over from the webs is removed from the surface of the back web, and the ready smart label inlet web is reeled up. In the ready smart label inlet web, the back web is uniformly continuous, but the surface web and the smart label web are punched into pieces separated from each other and having a fixed size. In this application, these pieces are referred to as the cover film and the smart label. It is also possible that the blank for a smart label inlet web is punched into pieces, separated from each other and having a fixed size, in such a way that the back web is also punched. In this way, smart label cards are formed.

The surface web protects the smart label web from external effects. The surface web prevents damage to the electrical properties of the circuit caused by the effect of moisture or mechanically. It also protects the integrated circuit on the chip as well as its attachment from ambient factors, mechanical stress and discharges of static electricity. All the above-mentioned phenomena may completely break the circuit or impair its efficiency.

The adhesive to be applied to the interface of the cover film and the smart label is an important factor in how successfully the smart label is protected from external effects and how well the underfill can be replaced by this adhesive. The hydrofobic/hydrophilic properties of the adhesive and the change of the mechanical properties by the effect of moisture must be taken into account. Particularly suitable adhesives for this purpose include, thanks to their low absorption of moisture, hot-melt adhesives, particularly adhesives which can be cross-linked by UV radiation, electron beam curing or microwave curing, and which can be transfer laminated. The adhesive layer formed on the release web of the surface web is transfer laminated, and after this, the polymer is cross-linked further. Cross-linking can be controlled by adjusting the energy supplied to the system. It is possible to use UV hot-melt adhesives, whose cross-linking can be adjusted by adjusting the quantity of the UV radiation. The radiation requires a protective film passing UV radiation, wherein for example polyethylene and polypropylene films are well suited for the purpose. It is also possible to cure the adhesive by electron beam (EB) curing, wherein it is possible to use a range of films with a larger material basis than when UV radiation is used, because in this case the film does not need to pass UV radiation. When curing by an electron beam is used, the penetration depth must be suitably selected so that it will not affect the functional properties of the chip. When using an adhesive that is cross-linked by radiation, the web does not need to be subjected to a hard pressure in the nip upon attaching the webs, because the adhesion of the adhesive can be improved by cross-linking after the nip.

It is also possible that the smart label web is laminated between the surface and back webs in such a way that the back web is not intended to be removed at a stage of further processing, but it is punched into a back film having a fixed size and remaining in its position also in the final product. In this way, a card is formed which can be used e.g. as a disposable charge card, such as a ticket or a charge card for a bus. Such a card can also be used as a product control means, for example sewn or heat-sealed inside a garment. The surface and back webs of such cards can be made of for example plastic, paper or board. In cases in which the material does not pass UV radiation, a suitable curing method is curing by an electron beam. For the curing, also microwave curing can be used. In these uses, properties that can be required of the surface and back webs include suitability for heat sealing, rigidity, and good mechanical, optical and visual properties.

The speed used in the process of manufacturing the smart label inlet web is relatively slow, wherein a good result is obtained with a long nip time in a soft and long nip. The long nip can be formed for example between two rolls or between a roll and a resilient belt. In a nip formed by two rolls, at least one of the rolls has a resilient surface, wherein at least part of the material of the roll can be of elastomer. It is also possible that both of the rolls forming the nip have a resilient surface. The tension of the back and surface webs is adjusted by methods known as such, but the smart label web is slack when it is led to lamination. By simultaneous lamination of the surface web and the back web, the risk of breaking the smart label is reduced, when it is run only once through the nip in the lamination process. Similarly, by using a long, soft nip, the risk of breaking is reduced, when the smart label is subjected to a low surface pressure when compared with using a hard nip. Furthermore, the path of the smart label is more straight in a soft nip than in a hard nip which may easily have quickly turning angles.

In further processing, the smart label inlet web is introduced between the surface and back webs in the process, and after that, the ready labels are possibly punched off the web, wherein separate smart label products are formed. In further processing, the labels can be printed, wherein for achieving a good printing result, the profile of the smart label product must be even. Problems in the smoothness are particularly caused by the chip of the smart label which forms a clear bulge on the surface of the smart label product. The bulge can be made smaller by trying to remove the adhesive layer of the surface web from the surface of the chip. A hot-melt adhesive, which is either a hot-melt adhesive cured by radiation, such as ultraviolet radiation or an electron beam, or a normal hot-melt adhesive that can be made fluid by heating, can be made to run off the surface of the chip. A hot-melt adhesive curable by ultraviolet radiation or by an electron beam can be left fluid upon the lamination of the surface web, wherein no additional heating is necessary. The adhesive running off the chip can form a part of the encapsulation of the chip, preventing the displacement of the chip on the surface of the smart label.

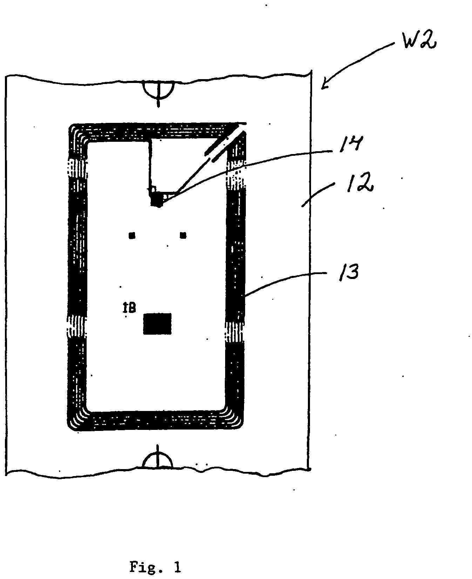

Referring now specifically to the appended drawings, Figure 1 shows a smart label web W2 in a top view, including a single smart label 12 comprising a circuitry pattern 13 and an integrated circuit 14 therein. The smart label 12 can be manufactured by printing the circuitry pattern on a film with an electroconductive printing ink, by etching the circuitry pattern on a metal film, by punching the circuitry pattern off a metal film, or by winding the circuitry pattern of e. g. a copper wire. The circuitry pattern is provided with an identification circuit, such as a radio frequency identification(RFID) circuit. The identification circuit is a simple electric oscillating circuit (RCL circuit) tuned to operate at a defined frequency. The circuit consists of a coil, a capacitor and a circuit integrated on a chip, consisting of an escort memory and an RF part for communication with a reader device. The capacitor of the RCL circuit can also be integrated on the chip.

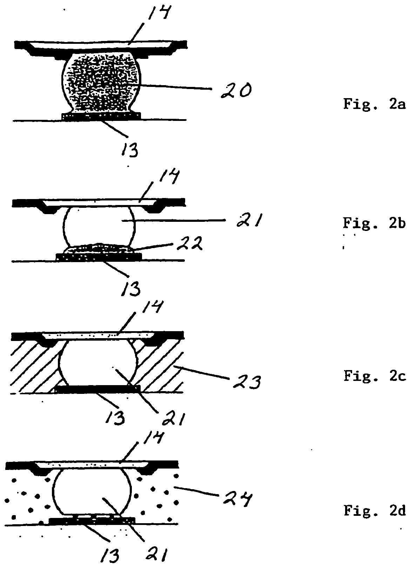

Figures 2a to 2d show possible techniques of attachment to be used for the attachment of an integrated circuit 14 to the circuitry pattern 13 of a smart label 12. Figure 2a shows a solder bump 20, by which the integrated circuit on the chip 14 is attached to the circuitry pattern 13. The solder bump 20 is made of a soldering paste.

Figure 2b shows a joint, in which an isotropically conductive adhesive 22 is attached to the circuitry pattern 13. A solder bump 21, which can be of gold or a mixture of gold and nickel, is attached to the isotropically conductive adhesive. The integrated circuit on the chip 14 is attached to the solder bump 21.

Figure 2c shows a joint, in which a solder bump 21 is attached between the circuitry pattern 13 and the integrated circuit on the chip 14 and is encapsulated by a non-conductive adhesive 23.

Figure 2d shows a joint, in which a solder bump 21 is attached between the circuitry pattern 13 and the integrated circuit on the chip 14 and is encapsulated by an anisotropically conductive adhesive 24.

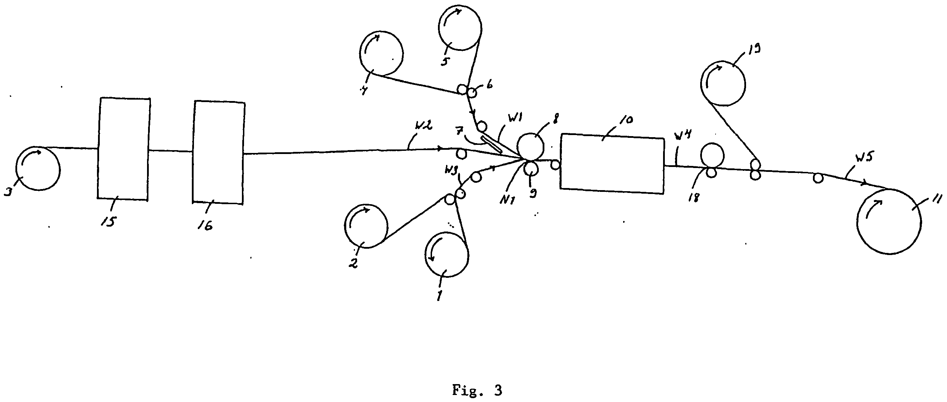

Figure 3 shows a process for the manufacture of a smart label inlet web, in which the attachment of the integrated circuit on the chip 14 and the manufacture of the smart label inlet web W5 are integrated on the same line. The smart label web W2 containing smart labels 12 one after another on a carrier web, is unwound from a reel 3. The carrier web may also contain several smart labels side by side. The material of the smart label web W2, onto whose surface the circuitry pattern is formed and the integrated circuit is attached, is preferably a plastic film with a suitable rigidity.

A solder bump is placed onto the surface of the smart label web W2, at a suitable location in the smart label, in a solder bump forming unit 15. The integrated circuit on the chip is placed onto and attached to the smart label web W2 in an attaching unit 16.

A continuous web comprising a surface web W1 is unwound from a reel 5. From the reverse side of the surface web W1, the release web of the surface web is released and, after the releasing, it is reeled up on a roll 4. On the side where the release web was released, the surface web W1 is impregnated with an adhesive whose adhesion can be improved by heating it with a heater 7 which can be for example an infrared heater. In this application, the adhesive of the surface web W1 replaces the underfill and forms a protective encapsulation suitable for the integrated circuit on the chip. The material of the surface web W1 is preferably a polyolefine film, such as a polypropylene or polyethylene film.

A continuous web comprising a back web W3 is unwound from a reel 1. From the reverse side of the back web W3, the release web of the back web is released and, after the releasing, it is reeled up on a roll 2. On the side where the release web was released, the back web W3 is provided with an adhesive. The adhesive can be for example a pressure-sensitive adhesive which can be made to adhere to another surface by pressing it against the other surface.

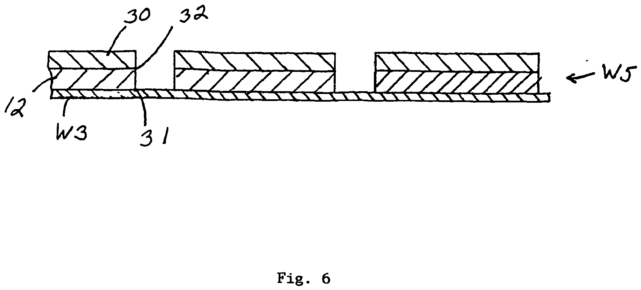

The surface web W1, the smart label web W2 and the back web W3 are attached to each other in a nip N1 formed by rolls 8 and 9, which is a resilient, long nip. The nip N1 is followed by a radiator device 10 to which the blank W4 of the smart label inlet web is led. The radiator device 10 can produce ultraviolet radiation or electron beams. The blank W4 of the smart label inlet web is further introduced to a punching unit 18 in which the surface web W1 and the smart label web W2 are punched at a suitable location so that the surface of the back web W3 is provided with a sequence of smart labels 12 of a fixed size and protective cover films on top of them (shown in Fig. 6). After the punching, excess parts of the liner web W1 and the smart label web W2 are left outside the smart label 12 and the cover film and are removed by reeling up the excess material on a reel 19. The ready made smart label inlet web W5 is reeled up on a reel 11.

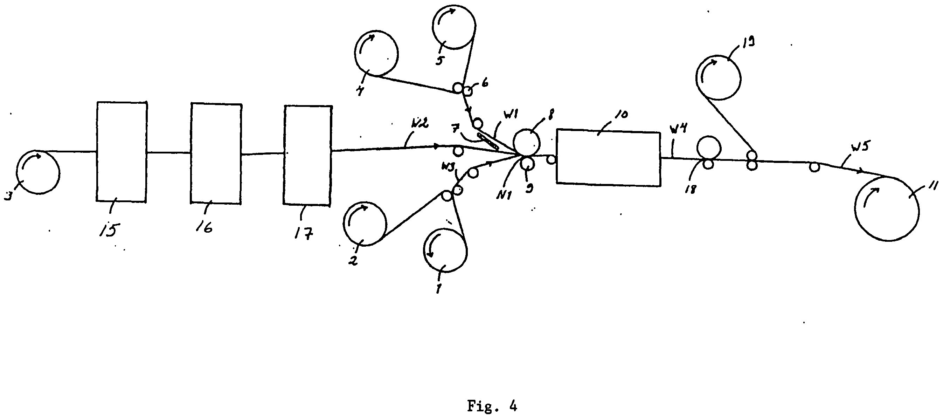

Figure 4 shows a process for the manufacture of a smart label inlet web, in which the attachment of the integrated circuit is also on the same production line as the attachment of the surface web, the smart label web and the back web. The solder bump is inserted in the circuitry pattern in the solder bump forming unit 15. The integrated circuit on the chip is attached to the circuitry pattern in the attaching unit 16, and the underfill is pre-cured. The final curing of the underfill takes place in a curing unit 17. After this, the manufacturing process is continued as presented in the description of Fig. 3.

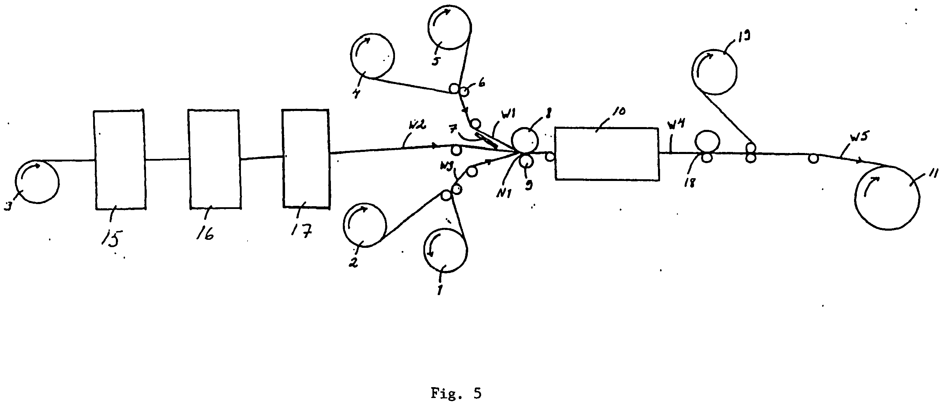

Figure 5 shows a process for the manufacture of a smart label inlet web, in which the attachment of the integrated circuit is also on the same production line as the attachment of the surface web, the smart label web and the back web. In this process, it is possible to use either an anisotropically conductive adhesive or a film or a non-conductive adhesive.

The smart label web W2 containing smart labels 12 one after another on a carrier web, is unwound from a reel 3. The solder bump is formed in the circuitry pattern in the solder bump forming unit 15. The integrated circuit on the chip 14 is attached to the circuitry pattern and precured in the attaching unit 16. The final curing of the adhesive takes place under a pressure by means of installed thermal resistors in a curing unit 17. After this, the manufacturing process is continued as presented in the description of Fig. 3.

Figure 6 shows the cross-section of the ready smart label inlet web in the longitudinal direction of the web. The back web W3 is a continuous carrier web for the smart label 12 under the cover film. The surface web W1 and the smart label web W2 are punched as a cover film 30 and a smart label 12. The excess parts of the surface web W1 and the smart label web W2 left at the edges upon punching are removed from the back web W3. The interface 31 between the back web W3 and the smart label 12 is provided with an adhesive layer which can be for example a pressure-sensitive adhesive. The interface 32 between the smart label 12 and the cover film 30 is provided with an adhesive layer which is preferably a hot-melt adhesive cured by means of ultraviolet (UV) radiation or an electron beam (EB).

The back web W3 is a release paper whose surface on the side of the smart label 12 is treated in such a way that the smart label 12 and the cover film 30 can be easily detached together from the back web W3 at the interface 31. The cover film is a film passing UV radiation, such as a polyolefine film.

The invention is not restricted to the description above, but it may vary within the scope of the claims. In the attachment of a integrated circuit, such as a chip, it is possible to use either known attachment methods, or it is attached without an underfill. The adhesive used can differ from the one described above. The nip used for the attachment of the webs can be different, or it is possible to use an arrangement comprising several nips for the attachment of the webs.

## Claims

1. A method for the manufacture of a smart label inlet web (W5), in which method
a surface web (W1) provided with an adhesive on one side,
a smart label web (W2), on whose surface circuitry patterns of smart labels are formed, and
a back web (W3)
are combined into a blank for the smart label inlet web (W5),
**characterized in that**:
integrated circuits (14) are attached in a continuous manner to the circuitry pattern of each smart label (12) on the smart label web (W2) before the combination of the webs (W1, W2, W3) on the same production line;
the webs are combined so that the smart label web is laminated between the surface and back webs;
the adhesive provided on one side of the surface web (W1) forms encapsulation for the integrated circuits attached to the circuitry patterns on the smart label web (W2) ; and
the back web (W3) is a release paper.

2. The method according to Claim 1, **characterized in that** the integrated circuits (14) are attached to the circuitry pattern (13) of each smart label (12) by means of a solder bump (20,21) or by means of an isotropic adhesive (22) and a solder bump (21). ,

3. The method according to Claim 2, **characterized in that** an underfill is used in the attachment of the integrated circuits (14).

4. The method according to Claim 2, wherein the integrated circuits are attached by means of an isotropic adhesive (22) and a solder bump (21), **characterized in that** the adhesive of the surface web (W1) is used in place of an underfill in the attachment of the integrated circuits (14).

5. The method according to any of the preceding claims, **characterized in that** the surface web (W1), the smart label web (W2) and the back web (W3) are attached in the same nip (N1).

6. The method according to Claim 5, **characterized in that** at least one of the two contact surfaces forming the nip (N1) has a resilient surface.

7. The method according to Claim 5 or 6, **characterized in that** before the attachment of the webs (W1, W2, W3), release webs are released from the reverse side of the surface web (W1) and from the reverse side of the back web (W3).

8. The method according to any of the preceding claims, **characterized in that** the adhesive is applied to the one side of the surface web (W1) by transfer lamination, in contact with the smart label web (W2), and is cured by radiation.

9. The method according to Claim 8, **characterized in that** the adhesive on the one side of the surface web (W1) is cured by means of ultraviolet (UV) radiation or electron beam (EB) curing.

10. The method according to any of the preceding claims, **characterized in that** the surface web (W1) is a polyolefine film.

11. The method according to Claim 8, 9 or 10, **characterized in that**, after the radiation of the adhesive on the one side of the surface web (W1), the surface web (W1) and the smart label web (W2) are punched to leave a sequence of smart labels (12) attached to the back web (W3); and smart label web (W2) and surface web (W1) excess material is removed.

12. The method according to Claim 11, **characterized in that** the ready smart label inlet web (W5) thereby manufactured is reeled up on a roll (11).

13. The method according to Claim 8, 9 or 10, **characterized in that**, after the radiation of the adhesive on the one side of the surface web (W1), the smart labels (12), are punched out of the combined surface web (W1), smart label web (W2) and back web (W3).

14. A device for the manufacture of a smart label inlet web (W5), the device comprising means for combining: a surface web (W1) provided with an adhesive on one side; a smart label web (W2), on whose surface circuitry patterns of smart labels are formed; and a back web (W3) to laminate the smart label web (W2) between the surface and back webs, **characterized in that**: the device for the manufacture of a smart label inlet web (W5) further comprises means for attaching integrated circuits (14) in a continuous manner to the circuitry pattern of each smart label (12) on the smart label web (W2), on the same production line, before the combination of the webs; and the back web (W3) is a release paper.

15. The device according to Claim 14, **characterized in that** the means for attaching integrated circuits comprises a unit (15) for making a solder bump and a unit (16) for attaching a chip.

16. The device according to Claim 14 or 15, **characterized in that** the device comprises a curing unit (17).

17. The device according to Claim 14, **characterized in that** the means for combining the surface web (W1), the smart label web (W2) and the back web (W3) comprise a nip (N1) where at least one of the contact surfaces has a resilient surface.

18. The device according to any of the Claims 14 to 17, **characterized in that** the device comprises a radiation device (10).

## Patentansprüche

1. Verfahren zur Herstellung eines Smartetikett-Einlassgewebes (W5), bei welchem Verfahren
ein mit einem Haftmittel an einer Seite versehenes Flächengewebe (W1),
ein Smartetikettgewebe (W2), auf dessen Fläche Schaltkreismuster des Smartetiketts ausgebildet sind, und
ein rückseitiges Gewebe (W3)
zu einem Formling für das Smartetikett-Einlassgewebe (W5) kombiniert werden,
**dadurch gekennzeichnet, dass**
integrierte Schaltungen (14) kontinuierlich am Schaltkreismuster jedes Smartetiketts (12) am Smartetikettgewebe (W2) vor der Kombination der Gewebe (W1, W2, W3) auf der gleichen Produktionslinie angebracht werden,
die Gewebe derart kombiniert werden, dass das Smartetikettgewebe zwischen das Flächengewebe und das rückseitige Gewebe geschichtet wird,
das an einer Seite des Flächengewebes (W1) vorgesehene Haftmittel eine Kapselung für die integrierten Schaltungen ausbildet, die an den Schaltkreismustern am Smartetikettgewebe (W2) angebracht sind, und
das rückseitige Gewebe (W3) ein Trennpapier ist.

2. Verfahren gemäß Anspruch 1, **dadurch gekennzeichnet, dass** die integrierten Schaltungen (14) am Schaltkreismuster (13) jedes Smartetiketts (12) mittels einer Lötperle (20, 21) oder mittels eines istropen Haftmittels (22) und einer Lötperle (21) angebracht sind.

3. Verfahren gemäß Anspruch 2, **dadurch gekennzeichnet, dass** eine Unterfüllung bei der Anbringung der integrierten Schaltungen (14) verwendet wird.

4. Verfahren gemäß Anspruch 2, bei dem die integrierten Schaltungen mittels eines isotropen Haftmittels und einer Lötperle (21) angebracht sind, **dadurch gekennzeichnet, dass** das Haftmittel des Flächengewebes (W1) anstelle einer Unterfüllung bei der Anbringung der integrierten Schaltungen (14) verwendet wird.

5. Verfahren gemäß einem der vorangegangenen Ansprüche, **dadurch gekennzeichnet, dass** das Flächengewebe (W1), das Smartetikettgewebe (W2) und das rückseitige Gewebe (W3) im gleichen Spalt (N1) angebracht werden.

6. Verfahren gemäß Anspruch 5, **dadurch gekennzeichnet, dass** zumindest eine der beiden den Spalt (N1) ausbildenden Kontaktflächen eine nachgiebige Fläche aufweist.

7. Verfahren gemäß Anspruch 5 oder 6, **dadurch gekennzeichnet, dass** vor der Anbringung der Gewebe (W1, W2, W3) Trenngewebe von der umgekehrten Seite des Flächengewebes (W1) und von der umgekehrten Seite des rückseitigen Gewebes (W3) gelöst werden.

8. Verfahren gemäß einem der vorangegangenen Ansprüche,
**dadurch gekennzeichnet, dass** das Haftmittel an der einen Seite des Flächengewebes (W1) durch Transferbeschichtung in Kontakt mit dem Smartetikettgewebe (W2) aufgebracht und durch Strahlung ausgehärtet wird.

9. Verfahren gemäß Anspruch 8, **dadurch gekennzeichnet, dass** das Haftmittel an der einen Seite des Flächengewebes (W1) mittels ultravioletter (UV) Strahlung oder Elektronenstrahl- (EB) Härtung ausgehärtet wird.

10. Verfahren gemäß einem der vorangegangenen Ansprüche,
**dadurch gekennzeichnet, dass** das Flächengewebe (W1) ein Polyolefin-Film ist.

11. Verfahren gemäß einem der Ansprüche 8, 9 oder 10,
**dadurch gekennzeichnet, dass** nach der Bestrahlung des Haftmittels an der einen Seite des Flächengewebes (W1) das Flächengewebe (W1) und das Smartetikettgewebe (W2) ausgestanzt werden, um eine Sequenz von Smartetiketten (12) übrig zu lassen, die am rückseitigen Gewebe (W3) angebracht sind, und ein übermäßiges Material des Smartetikettgewebes (W2) und des Flächengewebes (W1) entfernt wird.

12. Verfahren gemäß Anspruch 11, **dadurch gekennzeichnet, dass** das hierdurch hergestellte, fertige Smartetikett-Einlassgewebes (W5) auf einer Spule (11) aufgerollt wird.

13. Verfahren gemäß Anspruch 8, 9 oder 10, **dadurch gekennzeichnet, dass** nach der Bestrahlung des Haftmittels an der einen Seite des Flächengewebes (W1) die Smartetikette (12) aus dem kombinierten Flächengewebe (W1), Smartetikettgewebe (W2) und rückseitigen Gewebes (W3) ausgestanzt werden.

14. Vorrichtung zur Herstellung eines Smartetikett-Einlassgewebes (W5), wobei die Vorrichtung ein Mittel zum Kombinieren eines Flächengewebes (W1), das mit einem Haftmittel an einer versehen ist, eines Smartetikettgewebes (W2), an dessen Fläche Schaltkreismuster von Smartetiketten ausgebildet sind, und eines rückseitigen Gewebes (W3) zum Schichten des Smartetikettgewebes (W2) zwischen das Flächengewebe und das rückseitige Gewebe aufweist, **dadurch gekennzeichnet, dass** die Vorrichtung zur Herstellung eines Smartetikett-Einlassgewebes (W5) ferner ein Mittel zum kontinuierlichen Anbringen von integrierten Schaltungen (14) an den Schaltkreismustern jedes Smartetiketts (12) am Smartetikettgewebe (W2) auf der gleichen Produktionslinie vor der Kombination der Gewebe aufweist, und das rückseitige Gewebe (W3) ein Trennpapier ist.

15. Vorrichtung gemäß Anspruch 14, **dadurch gekennzeichnet, dass** das Mittel zum Anbringen von integrierten Schaltungen eine Einheit (15) zum Anfertigen einer Lötperle und eine Einheit (16) zum Anbringen eines Chips aufweist.

16. Vorrichtung gemäß Anspruch 14 oder 15, **dadurch gekennzeichnet, dass** die Vorrichtung eine Aushärtungseinheit (17) aufweist.

17. Vorrichtung gemäß Anspruch 14, **dadurch gekennzeichnet, dass** das Mittel zum Kombinieren des Flächengewebes (W1), des Smartetikett-Gewebes (W2), und des rückseitigen Gewebes (W3) einen Spalt (N1) hat, wo zumindest eine der Kontaktflächen eine nachgiebige Fläche aufweist.

18. Vorrichtung gemäß einem der Ansprüche 14 bis 17, **dadurch gekennzeichnet, dass** die Vorrichtung eine Bestrahlungsvorrichtung (10) aufweist.

## Revendications

1. Procédé de fabrication d'une bande continue d'étiquettes à puce (W5), procédé dans lequel
une bande de surface (W1) munie d'un adhésif sur une face,
une bande d'étiquettes à puce (W2), sur la surface de laquelle des motifs de circuits d'étiquettes à puce sont formés, et
une bande de dos (W3)
sont combinés en un flanc pour la bande continue d'étiquettes à puce (W5),
**caractérisé en ce que** :
des circuits intégrés (14) sont fixés en continu au motif de circuits de chaque étiquette à puce (12) sur 1 bande d'étiquettes à puce (W2) avant la combinaison des bandes (W1, W2, W3) sur la même ligne de production ;
les bandes sont combinées de sorte que la bande d'étiquettes à puce soit déposée en couche entre la surface et des bandes de dos ;
l'adhésif prévu sur une face de la bande de surface (W1) forme une encapsulation pour les circuits intégrés fixés aux motifs de circuits sur la bande d'étiquettes à puce (W2) ; et
la bande de dos (W3) est un intercalaire.

2. Procédé selon la revendication 1, **caractérisé en ce que** les circuits intégrés (14) sont fixés au motif de circuits (13) de chaque étiquette à puce (12) au moyen d'une bosse de soudure (20, 21) ou au moyen d'un adhésif isotrope (22) et d'une bosse de soudure (21).

3. Procédé selon la revendication 2, **caractérisé en ce qu'**un sous-remplissage est utilisé dans la fixation des circuits intégrés (14).

4. Procédé selon la revendication 2, dans lequel les circuits intégrés sont fixés au moyen d'un adhésif isotrope (22) et d'une bosse de soudure (21), **caractérisé en ce que** l'adhésif de la bande de surface (W1) est utilisé à la place d'un sous-remplissage dans la fixation des circuits intégrés (14).

5. Procédé selon l'une quelconque des revendications précédentes, **caractérisé en ce que** la bande de surface (W1), la bande d'étiquettes à puce (W2) et la bande de dos (W3) sont fixées dans la même ligne de contact (N1).

6. Procédé selon la revendication 5, **caractérisé en ce qu'**au moins l'une des deux surfaces de contact formant la ligne de contact (N1) a une surface résiliente.

7. Procédé selon la revendication 5 ou 6, **caractérisé en ce qu'**avant la fixation des bandes (W1, W2, W3), des bandes de dégagement sont dégagées de la face inverse de la bande de surface (W1) et de la face inverse de la bande de dos (W3).

8. Procédé selon l'une quelconque des revendications précédentes, **caractérisé en ce que** l'adhésif est appliqué à une face de la bande de surface (W1) par stratification par transfert, en contact avec la bande d'étiquettes à puce (W2), et est durci par irradiation.

9. Procédé selon la revendication 8, **caractérisé en ce que** l'adhésif sur la face de la bande de surface (W1) est durci par des rayons ultraviolets (UV)- ou par durcissement aux faisceau d'électrons (EB).

10. Procédé selon l'une quelconque des revendications précédentes, **caractérisé en ce que** la bande de surface (W1) est un film de polyoléfine.

11. Procédé selon la revendication 8, 9 ou 10, **caractérisé en ce qu'**après l'irradiation de l'adhésif sur une face de la bande de surface (W1), la bande de surface (W1) et la bande d'étiquettes à puce (W2) sont perforées pour laisser une séquence d'étiquettes à puce (12) attachée à la bande de dos (W3) ; et un matériau en excès de la bande d'étiquettes à puce (W2) et de la bande de surface (W1) est retiré.

12. Procédé selon la revendication 11, **caractérisé en ce que** la bande continue d'étiquettes à puce (W5) ainsi fabriquée est enroulée sur un rouleau (11).

13. Procédé selon la revendication 8, 9 ou 10, **caractérisé en ce qu'**après l'irradiation de l'adhésif sur une face de la bande de surface (W1), les étiquettes à puce (12), sont perforées dans la bande de surface (W1), la bande d'étiquettes à puce (W2) et la bande de dos (W3) combinées.

14. Dispositif de fabrication d'une bande continue d'étiquettes à puce (W5), le dispositif comprenant des moyens pour combiner : une bande de surface (W1) munie d'un adhésif sur une face ; une bande d'étiquettes à puce (W2), sur la surface de laquelle des motifs de circuits d'étiquettes à puces sont formés, et une bande de dos (W3) pour déposer en couche la bande d'étiquettes à puce (W2) entre la surface et des bandes de dos, **caractérisé en ce que** : le dispositif destiné à fabriquer une bande continue d'étiquettes à puce (W5) comprend en outre un moyen pour fixer des circuits intégrés (14) en continu au motif circuits de chaque étiquette à puce (12) sur la bande d'étiquettes à puce (W2), sur la même ligne de production, avant la combinaison des bandes ; et la bande de dos (W3) est un intercalaire.

15. Dispositif selon la revendication 14, **caractérisé en ce que** le moyen de fixation des circuits intégrés comporte une unité (15) pour réaliser une bosse de soudure et une unité (16) pour fixer une puce.

16. Dispositif selon les revendications 14 ou 15, **caractérisé en ce que** le dispositif comprend une unité de durcissement (17).

17. Dispositif selon la revendication 14, **caractérisé en ce que** le moyen de combinaison de la bande de surface (W1), de la bande d'étiquettes à puce (W2) et de la bande de dos (W3) comprend une ligne de contact (N1) où au moins l'une des surfaces de contact a une surface résiliente.

18. Dispositif selon l'une quelconque des 14 revendications à 17, **caractérisé en ce que** le dispositif comprend un appareil d'irradiation (10).
